# EUROPEAN PATENT APPLICATION

(11) **EP 0 588 093 A1**
(43) Date of publication of application: **23.03.1994**
(21) Application number: 93113276.5
(22) Date of filing: 19.08.1993
(51) Int. Cl.: H05K 1/09, H01L 23/498

(54) **Method of treating surface of wiring on circuit board**

(30) Priority: 20.08.1992 JP 221824/92
(71) Applicant: Kabushiki Kaisha Toyoda Jidoshokki Seisakusho, Aichi-ken 448 (JP); TOYOTA JIDOSHA KABUSHIKI KAISHA, Aichi-ken 471 (JP)
(72) Inventor: Miyazaki, Yukiyasu, c/o K.K. Toyoda Jidoshokki, Kariya-shi, Aichi-ken (JP); Sugitani, Nobuyoshi,, Toyota-shi, Aichi-ken (JP); Shimojo, Yoshiaki,, Kokubu, Kagoshima, (JP)
(74) Representative: Bühling, Gerhard, Dipl.-Chem.

(57) **Abstract**

Disclosed is a method for treating a surface of wiring on a circuit board. Wiring (12) of tungsten (W), copper (Cu) and any of their alloys is formed on a circuit board (11). A nickel alloy layer (20) containing boron (B) is formed as a film on the surface of the wiring (12). An electronic component (16,18) is connected to the nickel alloy layer (20) by means of a solder (17) and an aluminum bonding wire (19). The Ni-B alloy layer (20) has a boron content of about 1% by weight and is formed by electroplating or the like. The Ni-B alloy layer (20) should have a film thickness of 5 µm or more.

## Description

### BACKGROUND OF THE INVENTION

### Field of the Invention

The present invention relates to a method for treating a surface of wiring on a circuit board, and, more particularly, to a method for treating a surface of wiring on a circuit board on which a semiconductor device (bear chip) and various components (chip components) are to be mounted.

### Description of the Related Art

Semiconductor chip components, such as a memory and a microprocessor, are mounted on a circuit board and are electrically connected by wiring on the board.

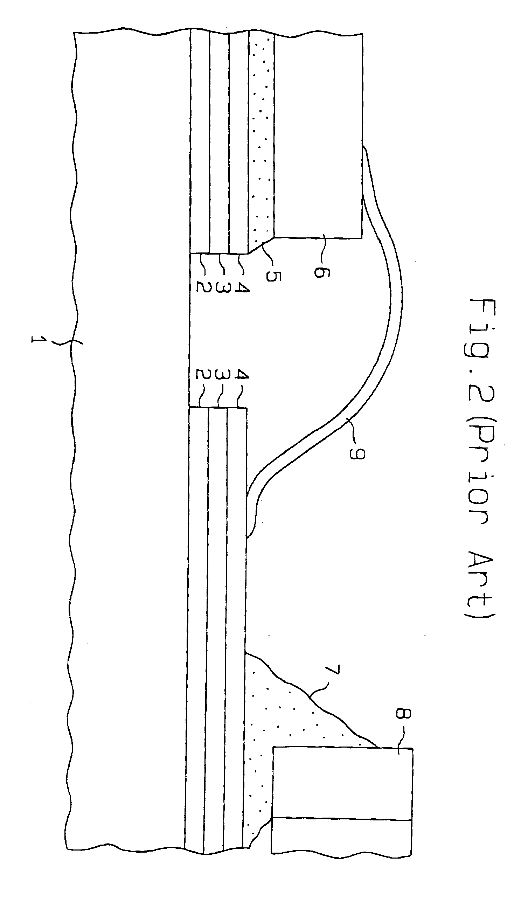

Fig. 2 is a cross section showing the essential portion of the wiring provided by a conventional method for treating a surface of wiring on a circuit board.

According to the conventional wire forming method, first, a wiring layer 2 of W (tungsten) is formed on a ceramic lamination board 1. The wiring layer 2 is formed by making the screen print of a wiring pattern on the board 1 and then sintering the resultant structure. In the screen printing, a paste containing W is coated on the board 1 to draw the wiring pattern.

An Ni (nickel) layer 3 is formed on the wiring layer 2 by electroplating, electroless plating, sputtering, vapor deposition or the like. Likewise, an Au (gold) layer 4 is formed on the Ni layer 3 by electroplating, electroless plating, sputtering, vapor deposition or the like.

A semiconductor device 6 is connected via a connect layer 5 with the top of the Au layer 4. Further, a chip component 8 is connected with the top of the Au layer 4 by solder 7. That Au layer 4 to which the chip component 8 is soldered and the semiconductor device 6 are connected together by a bonding wire 9 of AI (aluminum) to provide electric connection of the chip component 8 to the semiconductor device 6. The Ni layer 8 is deposited on the wiring layer 2 because of making a under coat for plating Au thereon.

Further, the Au layer 4 is deposited on the Ni layer 3 because if the Ni layer 3 is exposed, a strong and firm oxide layer would be formed on the surface of the Ni layer 3. If the chip component 8 is directly connected with the Ni layer 3 by the solder 7, the oxide layer on the Ni layer 3 reduces wettability and bonding properties with respect to molten solder. This decreases the working efficient and cannot provide sufficient bonding strength between the Ni layer 3 and the solder 7. Because of the same reasons given above, the bonding wire 9 of AI cannot be connected directly with the Ni layer 3. In this respect, the Au layer 4, which has excellent bonding properties to the AI bonding wire 9 and excellent wettability to molten solder, is formed on the Ni layer 3.

While having an excellent wettability to molten solder, the Au layer 4 involves a problem that it has poor bonding properties thereto.

For instance, as Au is easily dissolved in molten solder, Sn (tin) in the solder forms a complicated intermetallic compound with Au from the interface of the Au layer 4 and the solder 7 toward the individual layers at the time of applying the solder 7 on the Au layer 4. This intermetallic compound layer has a low mechanical strength and is brittle in addition to low durability to various temperature conditions. This compound layer particularly has low durability to a heat cycle in which a low temperature condition and a high temperature condition are alternately repeated.

When the board 1 having the above-described wiring pattern is subjected to a heat cycle test, therefore, cracks are likely to occur on the intermetallic compound layer due to the stress generated during the test, increasing the wire resistance, or the Au layer 4 may be separated from the solder 7 at the worst, causing the removal of the chip component 8.

### SUMMARY OF THE INVENTION

It is therefore a primary object of the present invention to provide a method for treating a surface of wiring on a circuit board, which can keep good bonding properties to an AI bonding wire.

It is another object of this invention to provide a method for treating a surface of wiring on a circuit board, which can keep good wettability and bonding properties to molten solder and can prevent the bonding properties from lowering by repetitive heat cycles.

To achieve the foregoing and other objects and in accordance with the purpose of the present invention, a method for treating a surface of wiring on a circuit board according to this invention forms wiring of a material selected from a group consisting of tungsten, copper and any of their alloys, on a circuit board, and forms, as a film, a nickel alloy layer having a boron content of about 1% by weight and a thickness of at least 5 /1.m on the surface of the wiring. An electronic component is connected with the nickel alloy layer by solder and an aluminum bonding wire.

### BRIEF DESCRIPTION OF THE DRAWINGS

The features of the present invention that are believed to be novel are set forth with particularity in the appended claims. The invention, together with objects and advantages thereof, may best be understood by reference to the following description of the presently preferred embodiments together with the accompanying drawings in which:
Fig. 1 is a cross section schematically showing an essential portion of wiring provided by a method for treating a surface of wiring on a circuit board according to the present invention; and
Fig. 2 is a cross section schematically showing an essential portion of wiring provided by a conventional method for treating a surface of wiring on a circuit board.

### DETAILED DESCRIPTION OF THE PREFERRED EMBODIMENT

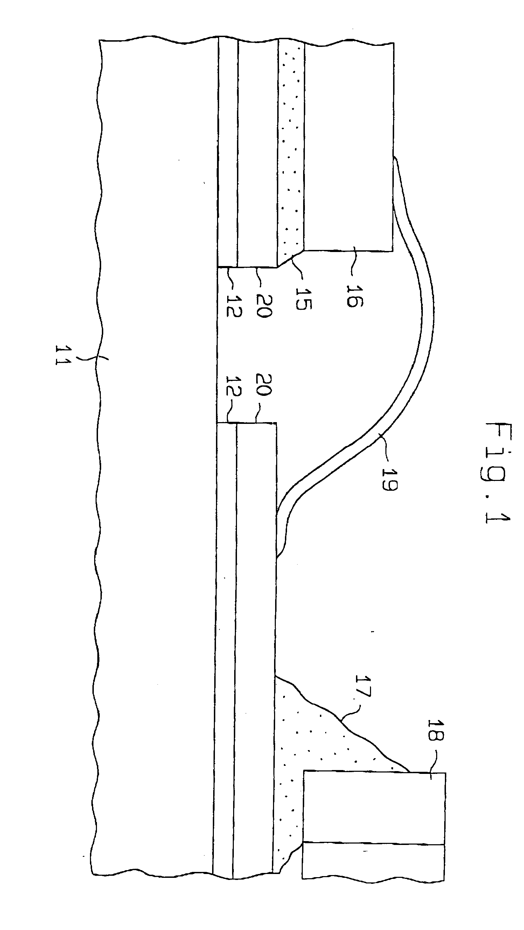

A preferred embodiment of the present invention will now be described referring to Fig. 1.

Fig. 1 presents a cross section schematically showing an essential portion of wiring provided by a method for treating a surface of wiring on a circuit board according to the present invention. According to this embodiment, first, a wiring layer 12 of W (tungsten) is formed on a ceramic lamination board 11. The material for the ceramic lamination board 11 is alumina, PZT (an oxide including lead, zirconium and titanium as main components), mullite, aluminum nitride or the like. The wiring layer 12 is formed by making the screen print of a wiring pattern on the board 11 and then sintering the resultant structure, as in the conventional method.

Then, an Ni-B (nickel-boron) alloy layer 20 is formed on the wiring layer 12. Subsequently, a semiconductor device 16 is connected via a connect layer 15 with the top of the Ni-B alloy layer 20. The material for the connect layer 15 is a brazing filler metal, such an an Ag (silver) paste or solder, or an adhesive such as an epoxy resin. Further, a chip component 18 is connected with the top of the Ni-B alloy layer 20 by solder 17. That NiB alloy layer 20 to which the chip component 18 is soldered and the semiconductor device 16 are connected together by a bonding wire 19 of AI (aluminum) to provide electric connection of the chip component 18 to the semiconductor device 16.

As is apparent from the above, this embodiment differs from the related art in that the Ni layer 3 and Au layer 4 in the related art shown in Fig. 2 is replaced with the Ni-B alloy layer 20.

The Ni-B alloy layer 20 has a boron (B) content of about 1 % by weight, and may be formed by any method, such as electroplating, electroless plating, sputtering or vapor deposition, but should have a film thickness of 5 /1.m or greater.

Ni-B alloy has excellent wettability to molten solder and has a dissolving rate in molten solder of about 1/1000 of that of Au. At the time the solder 17 is applied on the Ni-B alloy layer 20, therefore, Ni and B hardly form an intermetallic compound with Sn and Pb in the solder at the interface of the Ni-B alloy layer 20 and the solder 17. The bonding strength between the Ni-B alloy layer 20 and the solder 17 will hardly decrease even by repetitive heat cycles.

Further, B contained in Ni layer suppresses the oxidation of Ni layer. With the thickness of the Ni-B alloy layer 20 set to 5 /1.m or greater, sufficient bonding properties of the AI bonding wire 19 to the Ni-B alloy layer 20 can be provided.

As an Au bonding wire does not connect to the Ni-B alloy layer 20, this bonding wire cannot be used in place of the AI bonding wire 19.

As described above, the wiring according to this embodiment has excellent bonding properties to the AI bonding wire. In addition, the wiring has excellent wettability and bonding properties to molten solder, and the bonding properties will not decrease even by repetitive heat cycles.

The ceramic lamination board 11 may be replaced with any other circuit board (e.g., a printed circuit board, flexible board or the like, made of phenol resin, epoxy resin, polyamide resin, paper or glass fiber).

The wiring layer 12 may be formed of an alloy essentially consisting of W, only of Cu or of an alloy essentially consisting of Cu.

Disclosed is a method for treating a surface of wiring on a circuit board. Wiring (12) of tungsten (W), copper (Cu) and any of their alloys 10 formed on a circuit board (11). A nickel alloy layer (20) containing boron (B) is formed as a film on the surface of the wiring (12). An electronic component is connected to the nickel alloy layer (20) by means of a solder and an aluminum bonding wire. The Ni-B alloy layer (20) has a boron content of about 1% by weight and is formed by electroplating or the like. The Ni-B alloy layer (20) should have a film thickness of 5 µm or more.

## Claims

1. A method for treating a surface of wiring (12) on a circuit board (11) comprising the steps of forming wiring on the circuit board and connecting an electronic component to the wiring, characterized by:
a step of forming, as a film, a nickel alloy layer (20) containing boron on the surface of the wiring (12); and
a step of connecting the electronic component to the nickel alloy layer (20) by at least one of a solder and an aluminum bonding wire (19).

2. A method according to claim 1, wherein the wiring (12) is made of a material selected from the group consisting of tungsten, a tungsten alloy, copper and a copper alloy.

3. A method according to Claim 1 or 2, wherein the nickel alloy layer (20) has a film thickness of at least 5 µm.

4. A method according to any one of Claims 1 to 3, wherein the nickel alloy layer (20) has a boron content of about 1 % by weight.

5. A method according to any one of Claims 1 to 4, wherein the nickel alloy layer (20) is formed by at least one of electroplating, electroless plating, sputtering and vapor deposition.

6. A method according to any one of Claims 1 to 5, wherein the circuit board (11) is made of a material selected from the group consisting of phenol resin, epoxy resin, polyamide resin, paper and glass fiber.

7. A method according to Claim 2, wherein the wiring (12) is formed by coating a paste containing the selected material of the wiring, on the circuit board (11) by screen printing to draw a wiring pattern and then sintering the resultant structure.

8. A method according to claim 6, wherein ceramic for forming the circuit board (11) consists of one composition selected from the group consisting of alumina, PZT, mullite and aluminum nitride.
